# EUROPÄISCHE PATENTSCHRIFT

(11) **EP 2 612 372 B1**
(45) Veröffentlichungstag und Bekanntmachung des Hinweises auf die Patenterteilung: **14.06.2017**
(21) Anmeldenummer: 11746232.5
(22) Anmeldetag: 17.08.2011
(51) Int. Cl.: H01L 33/22, H01L 25/075, H01L 33/00

(54) **LEUCHTDIODENCHIP**
LIGHT-EMITTING DIODE CHIP
PUCE DE DIODE ÉLECTROLUMINESCENTE

(30) Priorität: 02.09.2010 DE 102010036180
(43) Veröffentlichungstag der Anmeldung: 10.07.2013
(73) Patentinhaber: OSRAM Opto Semiconductors GmbH, 93055 Regensburg (DE)
(72) Erfinder: HÖPPEL, Lutz, 93087 Alteglofsheim (DE); VON MALM, Norwin, 93152 Nittendorf - Thumhausen (DE); SABATHIL, Matthias, 93059 Regensburg (DE)
(74) Vertreter: Epping - Hermann - Fischer
(86) Internationale Anmeldenummer: PCT/EP2011/064185
(87) Internationale Veröffentlichungsnummer: WO 2012/028460

(56) Entgegenhaltungen:
- WO-A1-2009/039212
- DE-A1- 19 945 465
- DE-A1-102008 039 790
- US-A1- 2005 287 687
- Wei-Tsai Liao ET AL: "Comparison of the Performance of InGaN/AlGaN MQW LEDs Grown on c-Plane and a-Plane Sapphire Substrates", ELECTROCHEMICAL AND SOLID-STATE LETTERS., vol. 10, no. 1, 1 January 2007 (2007-01-01), page H5, XP055282874, US ISSN: 1099-0062, DOI: 10.1149/1.2364379

## Beschreibung

Es wird ein Leuchtdiodenchip angegeben.

Die Druckschrift DE 10 2008 039790A1 beschreibt einen Leuchtdiodenchip gemäß dem Oberbegriff des Patentanspruchs 1.

Die Druckschriften WO 2009/039212A1, US 2005/287687A1 und DE 19945465A1 beschreiben Leuchtdiodenchips.

Eine zu lösende Aufgabe besteht darin, einen Leuchtdiodenchip anzugeben, der besonders kostengünstig hergestellt werden kann.

Die Aufgabe wird mit einem Leuchtdiodenchip gemäß Anspruch 1 gelöst.

Gemäß zumindest einer Ausführungsform des Leuchtdiodenchips umfasst der Leuchtdiodenchip einen Halbleiterkörper mit einem strahlungserzeugenden Bereich. Beispielsweise umfasst der Halbleiterkörper einen n-leitenden Bereich, einen p-leitenden Bereich und zumindest einen strahlungserzeugenden aktiven Bereich, der zwischen dem n-leitenden Bereich und dem p-leitenden Bereich angeordnet ist. Der Halbleiterkörper basiert dabei beispielsweise auf einem III/V-Verbindungs-Halbleitermaterial.

Ein III/V-Verbindungs-Halbleitermaterial weist wenigstens ein Element aus der dritten Hauptgruppe, wie beispielsweise B, Al, Ga, In, und ein Element aus der fünften Hauptgruppe, wie beispielsweise N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, beispielsweise Nitrid- und Phosphid-Verbindungshalbleiter. Eine solche binäre, ternäre oder quaternäre Verbindung kann zudem zum Beispiel ein oder mehrere Dotierstoffe sowie zusätzliche Bestandteile aufweisen.

Gemäß zumindest einer Ausführungsform des Leuchtdiodenchips umfasst der Leuchtdiodenchip zumindest zwei Kontaktstellen zum elektrischen Kontaktieren des aktiven Bereichs. Beispielsweise umfasst der Leuchtdiodenchip genau zwei Kontaktstellen. Mittels einer der Kontaktstellen kann der aktive Bereich p-seitig kontaktiert werden, mittels der anderen Kontaktstelle kann der aktive Bereich n-seitig kontaktiert werden.

Gemäß zumindest einer Ausführungsform umfasst der Leuchtdiodenchip einen Träger. Bei dem Träger handelt es sich dabei nicht um das Aufwachssubstrat, auf dem der Halbleiterkörper epitaktisch aufgewachsen ist, sondern um einen Träger, der erst nach dem Herstellen des Halbleiterkörpers mit dem Halbleiterkörper verbunden wird. Beispielsweise ist das Aufwachssubstrat vom Halbleiterkörper dann vollständig abgelöst. Das heißt, der Leuchtdiodenchip ist dann frei von einem Aufwachssubstrat. Der Träger übernimmt im Leuchtdiodenchip dann die Aufgabe der mechanischen Stabilisierung. Das heißt, der Träger trägt den Halbleiterkörper des Leuchtdiodenchips, derart, dass dieser bei normalem Gebrauch - beispielsweise beim Einbau in ein Gehäuse - nicht zerbricht oder auf andere Weise mechanischen Schaden nimmt.

Gemäß zumindest einer Ausführungsform des Leuchtdiodenchips ist ein Verbindungsmittel zwischen dem Träger und dem Halbleiterkörper angeordnet. Das heißt, der Halbleiterkörper ist mittels des Verbindungsmittels mechanisch mit dem Träger verbunden. Beispielsweise grenzt das Verbindungsmittel stellenweise direkt an den Halbleiterkörper und den Träger.

Gemäß zumindest einer Ausführungsform des Leuchtdiodenchips weist der Halbleiterkörper an seiner dem Träger zugewandten Außenfläche eine Aufrauung auf. Beispielsweise handelt es sich bei der dem Träger zugewandten Außenfläche um die ursprünglich dem Aufwachssubstrat des Halbleiterkörpers zugewandte Außenfläche des Halbleiterkörpers. Das heißt, von der aufgerauten Außenfläche des Halbleiterkörpers ist das Aufwachssubstrat entfernt und der Halbleiterkörper ist an seiner dem Träger zugewandten Außenfläche, welche eine Aufrauung aufweist, mittels des Verbindungsmittels mit dem Träger verbunden.

Der Halbleiterkörper ist dabei mittels des Verbindungsmittels zumindest mechanisch mit dem Träger verbunden, das heißt, das Verbindungsmittel muss keine elektrische Verbindung zwischen dem Träger und dem Halbleiterkörper herstellen, sondern das Verbindungsmittel sorgt lediglich dafür, dass es bei normalem Gebrauch des Leuchtdiodenchips nicht zu einem Ablösen des Halbleiterkörpers vom Träger kommen kann. Insbesondere ist es möglich, dass das Verbindungsmittel elektrisch isolierend ist.

Gemäß zumindest einer Ausführungsform des Leuchtdiodenchips steht das Verbindungsmittel stellenweise in direktem Kontakt mit dem Halbleiterkörper und dem Träger. Das heißt, an den aneinander zugewandten Flächen sind der Halbleiterkörper und der Träger mit dem Verbindungsmittel benetzt.

Gemäß zumindest einer Ausführungsform des Leuchtdiodenchips sind die zumindest zwei Kontaktstellen an der dem Träger abgewandten Oberseite des Halbleiterkörpers angeordnet. Das heißt, der Leuchtdiodenchip wird bevorzugt von der dem Träger abgewandten Seite her kontaktiert. Ein Stromfluss durch den Träger hindurch ist dann nicht möglich. Beispielsweise kann an der dem Halbleiterkörper abgewandten Seite des Trägers lediglich eine mechanische Befestigung des Leuchtdiodenchips beispielsweise auf einer Leiterplatte oder einem Leiterrahmen erfolgen. Die elektrische Kontaktierung geschieht dann über die zumindest zwei Kontaktstellen an der dem Träger abgewandten Oberseite des Halbleiterkörpers. Vorzugsweise handelt es sich dabei bei den Kontaktstellen um ungleichnamige Kontaktstellen, das heißt, der Halbleiterkörper wird von seiner dem Träger abgewandten Oberseite her n- und p-seitig kontaktiert.

Gemäß zumindest einer Ausführungsform des Leuchtdiodenchips umfasst der Leuchtdiodenchip einen Halbleiterkörper, der einen strahlungserzeugenden aktiven Bereich umfasst, zumindest zwei Kontaktstellen zum elektrischen Kontaktieren des aktiven Bereichs, einen Träger und ein Verbindungsmittel, das zwischen dem Träger und dem Halbleiterkörper angeordnet ist. Dabei weist der Halbleiterkörper an seiner dem Träger zugewandten Außenfläche eine Aufrauung auf, der Halbleiterkörper ist mittels des Verbindungsmittels mechanisch mit dem Träger verbunden, das Verbindungsmittel steht stellenweise in direktem Kontakt mit dem Halbleiterkörper und dem Träger und die zumindest zwei Kontaktstellen sind an der dem Träger abgewandten Oberseite des Halbleiterkörpers angeordnet.

Gemäß zumindest einer Ausführungsform des Leuchtdiodenchips handelt es sich bei dem Verbindungsmittel um einen elektrisch isolierenden Klebstoff. Das heißt, das Verbindungsmittel verbindet den Halbleiterkörper und den Träger mechanisch miteinander und sorgt für eine elektrische Isolation zwischen dem Halbleiterkörper und dem Träger. Bei dem elektrisch isolierenden Verbindungsmittel kann es sich dann beispielsweise um einen Siliziumdioxid-basierten Klebstoff handeln. Ferner kommen als elektrisch isolierende Klebstoffe Epoxide, Acrylate oder BCB in Frage. Alternativ oder zusätzlich können auch Silikon-basierte oder andere Kleber Verwendung finden, solange sie eine gute thermische Leitfähigkeit, eine gute Haftung an Träger und Halbleiterkörper und eine gute Strahlungsstabilität gegenüber der im aktiven Bereich des Leuchtdiodenchips erzeugten elektromagnetischen Strahlung aufweisen. Ferner kann es sich als vorteilhaft erweisen, wenn der Klebstoff klarsichtig oder strahlungsdurchlässig ist.

Gemäß zumindest einer Ausführungsform des Leuchtdiodenchips ist das Verbindungsmittel strahlungsdurchlässig.

Strahlungsdurchlässig bedeutet dabei, dass das Verbindungsmittel vorzugsweise wenigstens 50 %, besonders bevorzugt wenigstens 75 % der auf das Verbindungsmittel treffenden im strahlungserzeugenden aktiven Bereich des Halbleiterkörpers erzeugten elektromagnetischen Strahlung durchlässt. Beispielsweise ist es dabei möglich, dass das Verbindungsmittel klarsichtig ist.

Gemäß der erfindungsgemäßen Ausführungsform des Leuchtdiodenchips steht der Halbleiterkörper stellenweise in direktem Kontakt mit dem Träger. Das heißt, an Stellen im Verbindungsbereich zwischen Halbleiterkörper und Träger befindet sich kein Verbindungsmittel zwischen Halbleiterkörper und Träger, sondern Halbleiter und Träger stehen dort in direktem Kontakt miteinander. Dies erlaubt beispielsweise eine besonders gute Wärmeabfuhr aus dem Halbleiterkörper in den Träger.

Gemäß der erfindungsgemäßen Ausführungsform des Leuchtdiodenchips ist die Aufrauung des Halbleiterkörpers an seiner dem Träger zugewandten Außenfläche durch Erhebungen und Senken gebildet, das heißt die Aufrauung weist Erhebungen und Senken auf. Das Verbindungsmittel ist dabei zumindest stellenweise in den Senken angeordnet und die Spitzen der Erhebungen sind stellenweise frei von Verbindungsmittel. Diese Spitzen der Erhebungen können dann in direktem Kontakt mit dem Träger stehen. Dabei erweist sich eine Dicke der Verbindungsmittelschicht zwischen Träger und Halbleiterkörper von wenigstens 100 nm bis höchstens 1 µm als besonders vorteilhaft. Die Dicke der Verbindungsmittelschicht ist nicht notwendigerweise homogen, je nach der Tiefe der Senken beziehungsweise der Höhe der Erhebungen kann die Dicke der Verbindungsmittelschicht schwanken.

Gemäß zumindest einer Ausführungsform des Leuchtdiodenchips ist der Träger strahlungsdurchlässig. Für einen strahlungsdurchlässigen Träger eignet sich beispielsweise ein Träger, der mit Saphir gebildet ist oder aus Saphir besteht, besonders gut. Insbesondere kann die dem Halbleiterkörper zugewandte Oberfläche des Trägers eine Saphir A-Ebene sein. Das heißt zum Beispiel, bei dem Träger kann es sich insbesondere um so genannten "a-plane" Saphir handeln. Dies erweist sich aus den folgenden Gründen als vorteilhaft:
Beispielsweise auf GaN-basierende Leuchtdiodenchips werden oft auf Saphir als Aufwachssubstrat aufgewachsen. Um dabei einen hochwertigen Halbleiterkörper zu erhalten muss der Saphir in der Regel c-plane orientiert sein. Dies hat jedoch zur Folge, dass nur etwa 30 % des ursprünglichen Saphirkristalls zur Herstellung des Aufwachssubstrats genutzt werden können, da ein Saphirkristall in einem Ziehverfahren in "a-plane"-Richtung wächst. Auf "a-plane" kann man beispielsweise GaN-basierte Halbleiterkörper jedoch nicht mittels MOVPE mit hinreichend guter Kristallqualität aufwachsen. Bei einem hier beschriebenen Leuchtdiodenchip ist es möglich, das Aufwachssubstrat abzulösen und wieder zu verwenden. Als Träger kann dann der wesentlich kostengünstigere "a-plane" Saphir Verwendung finden.

Gemäß zumindest einer Ausführungsform des Leuchtdiodenchips ist der Träger strahlungsreflektierend. Der Träger kann dazu aus einem strahlungsreflektierenden Material, beispielsweise einem Metall, bestehen. Ferner ist es möglich, dass der Träger an seiner dem Halbleiterkörper zugewandten Oberseite eine reflektierende Schicht umfasst, die zur Reflexion von im aktiven Bereich erzeugter elektromagnetischer Strahlung reflektierend ausgebildet ist. Bei der reflektierenden Schicht kann es sich beispielsweise um eine metallische Schicht handeln, die mit Aluminium und/oder Silber und/oder Gold gebildet ist. Findet ein metallischer Träger Verwendung, kann dieser beispielsweise Aluminium enthalten oder aus Aluminium bestehen. Für die reflektierende Schicht ist es weiter möglich, dass es sich um eine dielektrische Schicht handelt, die beispielsweise nach Art eines Bragg-Spiegels oder eines dielektrischen Spiegels gebildet sein kann. Da über den Träger vorzugsweise kein elektrischer Strom in den Halbleiterkörper eingeprägt werden muss, ist die Verwendung einer elektrisch isolierenden reflektierenden Schicht möglich.

Gemäß zumindest einer Ausführungsform des Leuchtdiodenchips ist der Träger strahlungsstreuend ausgebildet. Das heißt, auf den Träger auftreffende und/oder in den Träger eindringende elektromagnetische Strahlung, die im strahlungserzeugenden aktiven Bereich erzeugt wird, wird gestreut. Der Träger kann dazu beispielsweise mit einem streuenden keramischen Material gebildet sein. Beispielsweise kann es sich dabei um gesintertes Al₂O₃ oder gesintertes AlN handeln. Die Lichtauskopplung aus dem Leuchtdiodenchip wird in diesem Fall zum Teil über absorptionsfreie Streuung erzielt.

Gemäß zumindest einer Ausführungsform des Leuchtdiodenchips sind vom Halbleiterkörper unbedeckte Bereiche der Außenfläche des Trägers von einer strahlungsreflektierenden Schicht bedeckt, wobei die Schicht zur Reflexion von im aktiven Bereich erzeugter elektromagnetischer Strahlung reflektierend ausgebildet ist. Beispielsweise handelt es sich bei der strahlungsreflektierenden Schicht um eine dielektrische Schicht, mit der die freie Außenfläche des Trägers verspiegelt ist. Handelt es sich dann beispielsweise um einen strahlungsdurchlässigen Träger, so wird die auf die Außenflächen des Trägers auftreffende elektromagnetische Strahlung so lange reflektiert, bis sie den Leuchtdiodenchip durch den Halbleiterkörper hindurch verlässt. An der aufgerauten Grenzfläche zwischen Halbleiterkörper und Träger ist aufgrund der Aufrauungen die Wahrscheinlichkeit für eine Totalreflexion reduziert, so dass die im aktiven Bereich erzeugte elektromagnetische Strahlung mit großer Effizienz aus dem Halbleiterkörper austreten kann.

Gemäß zumindest einer Ausführungsform des Leuchtdiodenchips erfolgt die elektrische Kontaktierung ausschließlich von der dem Träger abgewandten Oberseite des Halbleiterkörpers her. Das heißt, sämtliche zur elektrischen Kontaktierung notwendigen Kontaktstellen sind an der Oberseite des Halbleiterkörpers angeordnet, die dem Träger abgewandt ist. Durch den Träger fließt kein Strom, der zur Bestromung des aktiven Bereichs vorgesehen ist.

Gemäß zumindest einer Ausführungsform des Leuchtdiodenchips umfasst der Leuchtdiodenchip zumindest zwei Halbleiterkörper, wobei jeder Halbleiterkörper einen strahlungserzeugenden aktiven Bereich umfasst. Die Halbleiterkörper sind dabei derart voneinander getrennt, dass die strahlungserzeugenden aktiven Bereiche nicht miteinander zusammenhängen und beispielsweise getrennt voneinander betreibbar sind. Die Halbleiterkörper des Leuchtdiodenchips sind vorzugsweise elektrisch zueinander parallel und/oder in Reihe geschaltet. Dies kann beispielsweise mittels einer Verbindungsschicht realisiert sein, die an der dem Träger abgewandten Seite der Halbleiterkörper angeordnet sein kann. Beispielsweise verbindet die Verbindungsschicht zwei ungleichnamige Kontaktstellen benachbarter Halbleiterkörper miteinander.

Auf diese Weise ist ein Leuchtdiodenchip realisiert, der eine Vielzahl von Pixel aufweisen kann und, der - beispielsweise im Fall der Reihenschaltung - als sogenannter HochvoltLeuchtdiodenchip Verwendung finden kann. Das heißt, der Leuchtdiodenchip kann mit einer Spannung von beispielsweise wenigstens 8 V, vorzugsweise wenigstens 50 V, beispielsweise bei einer Netzspannung wie 110 V oder 230 V direkt betrieben werden. Der Leuchtdiodenchip kann dabei auch eine Gleichrichterschaltung und/oder zumindest einen Vorwiderstand umfassen, welche ebenfalls auf dem Träger des Leuchtdiodenchips angeordnet sein können.

Gemäß zumindest einer Ausführungsform des Leuchtdiodenchips umfasst die dem Träger zugewandte Seite des Halbleiterkörpers ein n-leitendes Halbleitermaterial. Mit anderen Worten ist der n-leitende Bereich des Halbleiterkörpers dem Träger zugewandt. Von der dem Träger abgewandten Seite her erstreckt sich dann zumindest eine Durchkontaktierung von einer der zumindest zwei Kontaktstellen durch den aktiven Bereich hindurch zum n-leitenden Halbleitermaterial. Die Durchkontaktierung kann dabei umlaufend vom Halbleitermaterial des Halbleiterkörpers umgeben sein.

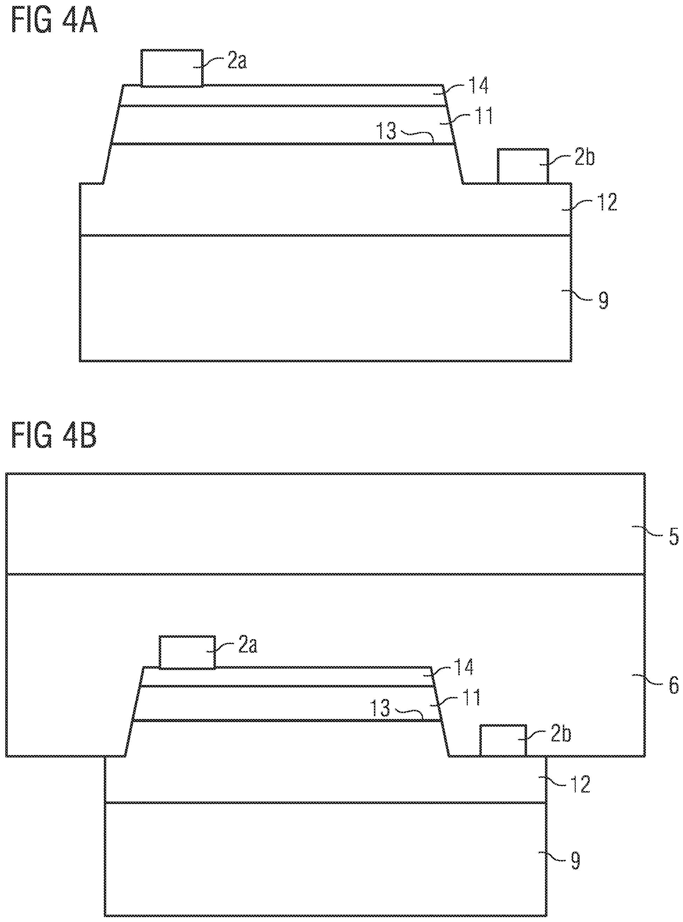

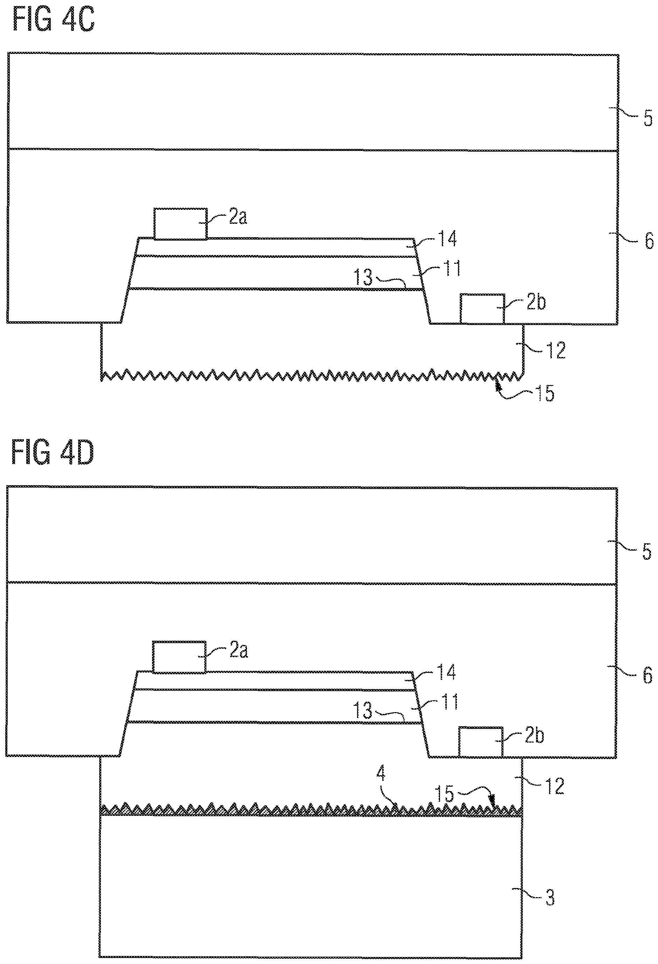

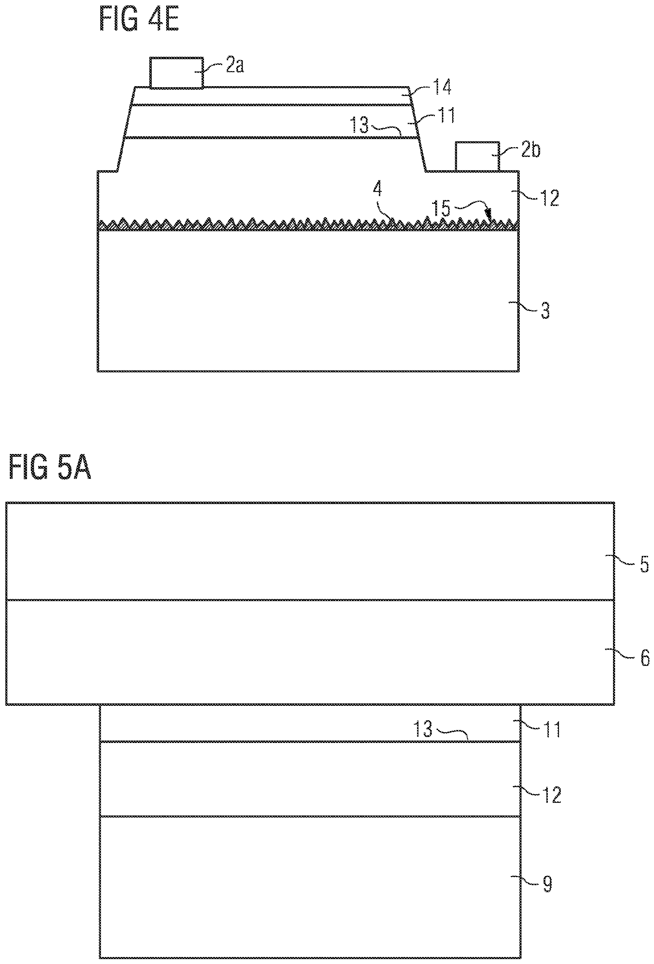

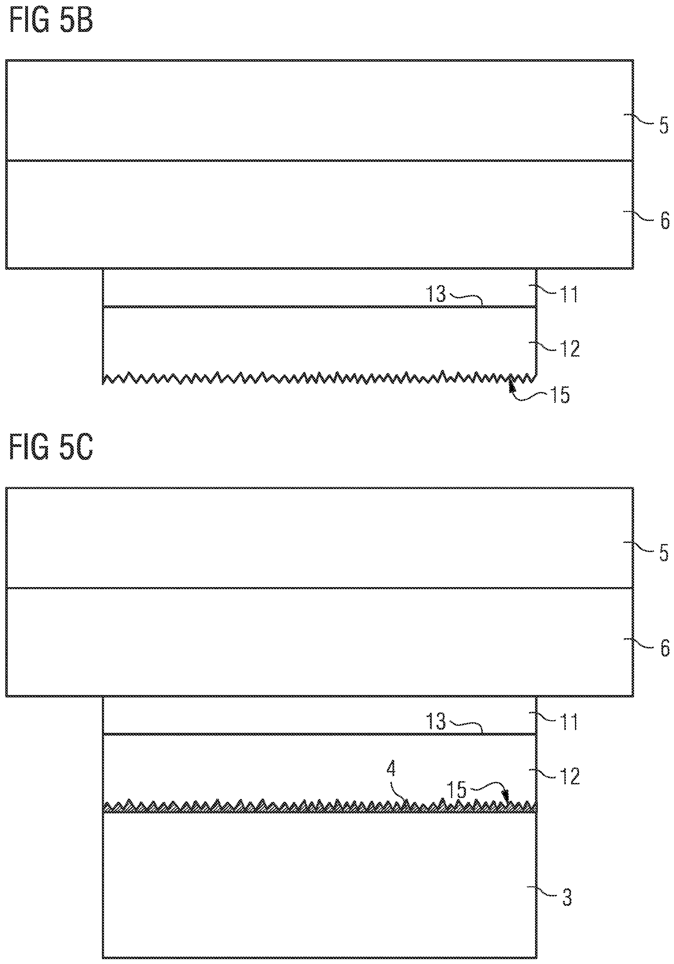

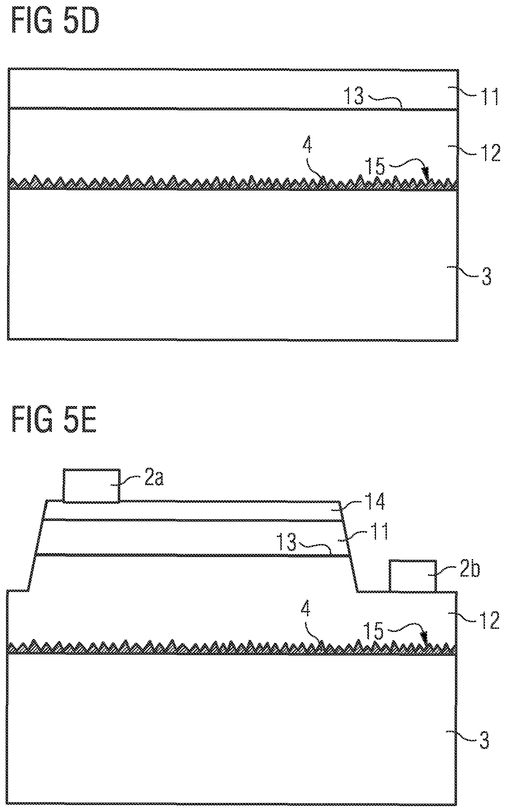

Im Folgenden wird der hier beschriebene Leuchtdiodenchip anhand von Ausführungsbeispielen und den dazugehörigen Figuren näher erläutert.

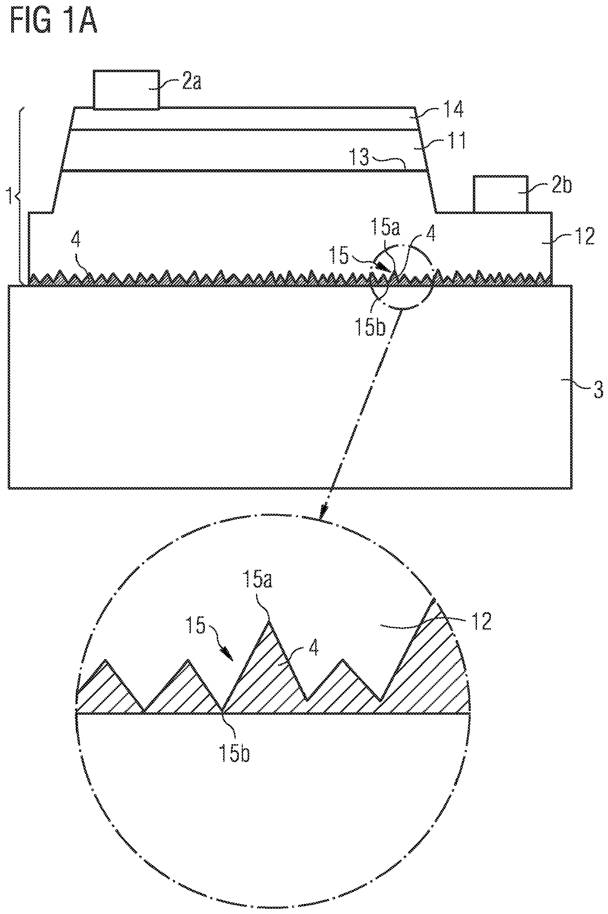

Die Figuren 1A, 1B, 1C, 2, 3 und 6 zeigen Ausführungsbeispiele von hier beschriebenen Leuchtdiodenchips.
In Verbindung mit den Figuren 4A, 4B, 4C, 4D, 4E, 5A, 5B, 5C, 5D und 5E sind Verfahren zur Herstellung von hier beschriebenen Leuchtdiodenchips näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1A zeigt eine schematische Schnittdarstellung eines Ausführungsbeispiels eines hier beschriebenen Leuchtdiodenchips. Der Leuchtdiodenchip umfasst einen Halbleiterkörper 1. Der Halbleiterkörper 1 weist einen p-leitenden Bereich 11, einen n-leitenden Bereich 12 sowie einen aktiven Bereich 13 auf, der zwischen p-leitendem Bereich 11 und n-leitendem Bereich 12 liegt. Im aktiven Bereich 13 wird im Betrieb des Leuchtdiodenchips elektromagnetische Strahlung, beispielsweise in einem Wellenlängenbereich von UV-Strahlung bis Infrarotstrahlung, erzeugt.

Der Leuchtdiodenchip weist ferner zwei Kontaktstellen 2a, 2b auf, mittels derer der aktive Bereich 13 von seiner p-Seite beziehungsweise seiner n-Seite her elektrisch kontaktiert wird. Zwischen dem p-leitenden Bereich 11 und der p-Kontaktstelle 2a kann eine Kontaktschicht 14 angeordnet sein, die beispielsweise zur Stromaufweitung dient. Beispielsweise ist es möglich, dass die Kontaktschicht mit einem transparenten leitfähigen Oxid (auch TCO, transparent conductive oxide) wie ITO oder ZNO gebildet ist.

Wie aus der Figur 1A ersichtlich, ist bei hier beschriebenen Leuchtdiodenchips vorzugsweise der n-leitende Bereich an seiner Außenfläche aufgeraut. Das heißt, der n-leitende Bereich weist Aufrauungen 15 auf. Die Aufrauungen 15 sind dabei vorzugsweise derart ausgestaltet, dass im aktiven Bereich erzeugte elektromagnetische Strahlung an Facetten der Aufrauungen gebrochen wird.

Die Aufrauungen 15 weisen Senken 15a und Erhebungen 15b auf. Die Aufrauungen weisen bevorzugt Tiefen zwischen wenigstens 1 µm und höchstens 2 µm auf. Dabei ist die Tiefe zum Beispiel der Abstand zwischen dem tiefsten Punkt einer Senke 15a und der Spitze einer benachbarten Erhebung 15b. Der Flankenwinkel der Aufrauungen beträgt zwischen bevorzugt zwischen wenigstens 45° und höchstens 60°.

Der Leuchtdiodenchip weist ferner einen Träger 3 auf. Der Träger 3 ist an der mit den Aufrauungen 15 versehenen Außenfläche des n-leitenden Bereichs an dem Halbleiterkörper 1 mechanisch befestigt. Bei der Oberfläche mit den Aufrauungen 15 des n-leitenden Bereichs 12 handelt es sich vorzugsweise um eine Oberfläche, von der das Aufwachssubstrat 9 (vergleiche dazu beispielsweise die Figur 4A) abgelöst wurde.

Zur mechanischen Verbindung zwischen Träger 3 und Halbleiterkörper 1 ist ein Verbindungsmittel 4 zwischen den beiden Elementen angeordnet. Das Verbindungsmittel 4 ist beispielsweise durch einen strahlungsdurchlässigen Klebstoff gebildet. Das Verbindungsmittel 4 ist zumindest in den Senken 15a der Aufrauung 15 angeordnet. Spitzen der Erhebungen 15b können aus dem Verbindungsmittel 4 ragen und befinden sich dann in direktem Kontakt mit dem Träger 3. Das heißt, vorzugsweise befindet sich das Verbindungsmittel 4 in direktem Kontakt mit dem Halbleiterkörper 1 und dem Träger 3 und es ist möglich, dass sich der Halbleiterkörper 1 an der dem Träger zugewandten Oberseite des n-leitenden Bereichs 12 in direktem Kontakt mit dem Träger 3 befindet.

Das Verbindungsmittel 4, also beispielsweise der Klebstoff, ist zum Beispiel durch Spincoating aufgebracht, was eine besonders große Homogenität der Verteilung des Verbindungsmittels ermöglicht. Die Schicht mit dem Verbindungsmittel 4 ist auf diese Weise beispielsweise im Wesentlichen frei von Lufteinschlüssen.

Im Ausführungsbeispiel der Figur 1A handelt es sich bei dem Träger beispielsweise um einen strahlungsdurchlässigen, klarsichtigen Träger, der mit a-plane Saphir gebildet ist oder aus a-plane Saphir besteht. Bei dem Verbindungsmittel handelt es sich dann vorzugsweise um einen klarsichtigen Klebstoff.

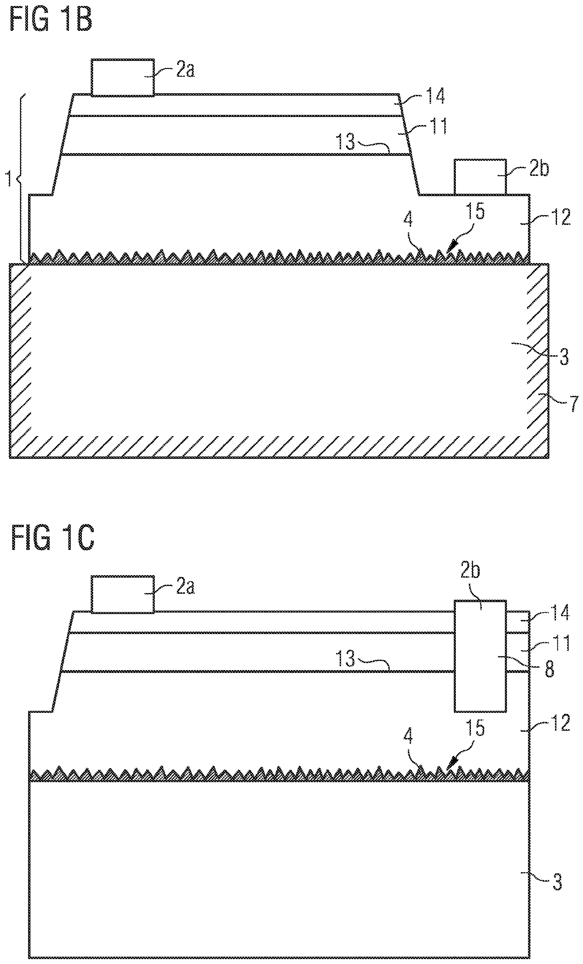

In Verbindung mit der Figur 1B ist ein weiteres Ausführungsbeispiel eines hier beschriebenen Leuchtdiodenchips näher erläutert. Im Unterschied zum Ausführungsbeispiel der Figur 1A weist der Träger 3 an seiner freien Außenfläche eine strahlungsreflektierende Schicht 7 auf, die beispielsweise durch eine dielektrische Beschichtung des Trägers gebildet ist. Im aktiven Bereich 13 erzeugte elektromagnetische Strahlung, die in den Träger 3 eindringt, wird von dieser Schicht in Richtung des Halbleiterkörpers 1 reflektiert. Es resultiert ein Oberflächenemitter, bei dem fast die gesamte vom Leuchtdiodenchip im Betrieb emittierte elektromagnetische Strahlung durch die den Träger 3 abgewandte Oberseite des Halbleiterkörpers 1 austritt.

In Verbindung mit der Figur 1C ist ein weiteres Ausführungsbeispiel eines hier beschriebenen Leuchtdiodenchips näher erläutert. In diesem Ausführungsbeispiel weist der Halbleiterkörper 1 eine Durchkontaktierung 8 auf, die sich von der dem Träger 3 abgewandten Oberseite des Halbleiterkörpers 1 zum n-leitenden Bereich 12 erstreckt, wobei die Durchkontaktierung 8 sowohl den p-leitenden Bereich 11 als auch den aktiven Bereich 13 durchdringt. Die Durchkontaktierung 8 kann beispielsweise durch ein Loch im Halbleiterkörper gebildet sein, das an seinen Seitenflächen mit einem elektrisch isolierenden Material beschichtet ist. Das verbleibende Loch ist dann mit einem elektrisch leitenden Material, zum Beispiel einem leitfähigen Kleber oder einem Metall gefüllt, das elektrisch leitend mit der n-Kontaktstelle 2b verbunden ist.

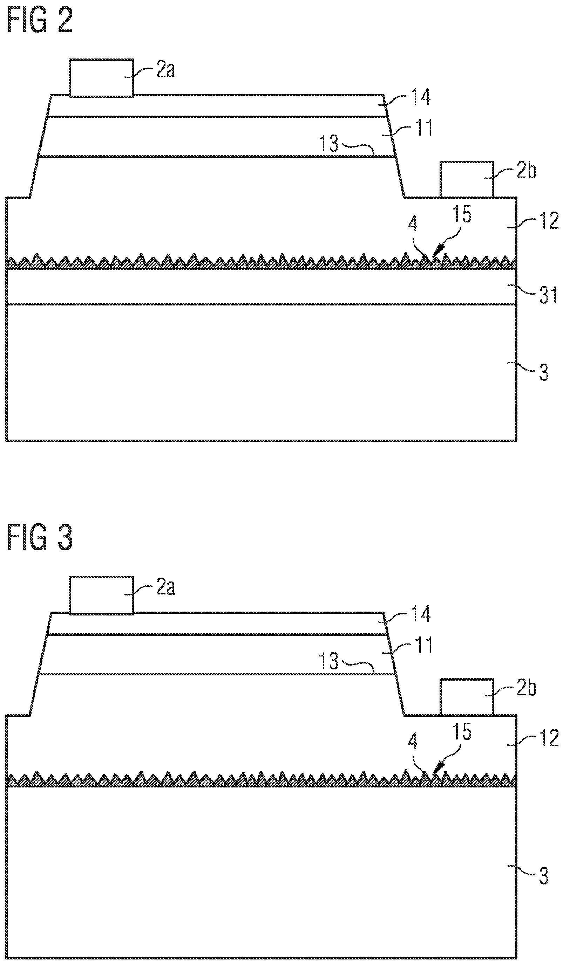

In Verbindung mit der Figur 2 ist ein weiteres Ausführungsbeispiel eines hier beschriebenen Leuchtdiodenchips näher erläutert. Im Unterschied zum Ausführungsbeispiel der Figuren 1A bis 1C weist der Träger hier an seiner dem Halbleiterkörper 1 zugewandten Seite eine reflektierende Schicht 31 auf. Die reflektierende Schicht 31 kann dielektrisch und/oder metallisch ausgebildet sein. Beispielsweise kann es sich um eine Schicht handeln, die Silber enthält oder aus Silber besteht. Vorliegend unterliegt die reflektierende Schicht 31 keinem elektrischen Feld, da der Leuchtdiodenchip ausschließlich von seiner dem Träger 3 abgewandten Seite her über die Kontaktstellen 2a, 2b bestromt wird. Vorteilhaft ergibt sich dabei, dass ein unter Feuchteeinwirkung zur Elektromigration neigendes Metall wie Silber ohne Gefährdung für den Leuchtdiodenchip eingesetzt werden kann. Es resultiert ein vorteilhafter Oberflächenemitter, bei dem ein Großteil der vom Leuchtdiodenchip im Betrieb emittierten Strahlung durch die dem Träger 3 abgewandte Oberseite des Halbleiterkörpers 1 ausgekoppelt wird.

In Verbindung mit der Figur 3 ist ein weiteres Ausführungsbeispiel eines hier beschriebenen Leuchtdiodenchips anhand einer schematischen Schnittdarstellung näher erläutert. In diesem Ausführungsbeispiel ist der Träger 3 lichtstreuend ausgebildet. Dazu besteht der Träger 3 beispielsweise aus einem keramischen Material wie gesintertem Al₂O₃. Das Verbindungsmittel 4 kann strahlungsdurchlässig oder strahlungsstreuend ausgebildet sein.

Die Strahlungsstreuung am Träger 3 erfolgt dabei verlustfrei, was einen Leuchtdiodenchip ermöglicht, der überwiegend durch seine dem Träger 3 abgewandte Oberseite des Halbleiterkörpers 1 emittiert, wobei am Träger 3 keine Reflexionsverluste auftreten.

In Verbindung mit den schematischen Schnittdarstellungen der Figuren 4A bis 4E ist ein erstes Verfahren zur Herstellung eines hier beschriebenen Leuchtdiodenchips näher erläutert.

In einem ersten Verfahrensschritt, Figur 4A, wird ein Leuchtdiodenchip beispielsweise im Waferverbund bereitgestellt, wobei der Halbleiterkörper 1 noch auf das Aufwachssubstrat 9 aufgebracht ist, auf dem die Halbleiterschichten des Halbleiterkörpers 1 epitaktisch abgeschieden sind. Der Leuchtdiodenchip ist bereits betriebsfertig kontaktiert.

In einem nächsten Verfahrensschritt, Figur 4B wird der Leuchtdiodenchip mittels eines weiteren Verbindungsmittels, zum Beispiel eines Klebstoffes, mit einem Zwischenträger 5 verbunden. Der Zwischenträger 5 ist derart gewählt, dass er für ein Ablösen des Aufwachssubstrates 9 eine ausreichende Stabilität zur Verfügung stellt.

In einem nächsten Verfahrensschritt, Figur 4C, wird das Aufwachssubstrat 9 beispielsweise mittels eines Laser-Lift-off-Verfahrens vom Halbleiterkörper 1 abgelöst. Gleichzeitig oder anschließend kann die Aufrauung 15 an der dem ursprünglich vorhandenen Aufwachssubstrat 9 zugewandten Seite des n-leitenden Bereichs 12 erzeugt werden. Beispielsweise wird die Aufrauung mittels Ätzens (zum Beispiel mit heißer KOH) erzeugt.

In einem weiteren Verfahrensschritt, Figur 4D, wird der Träger 3 mittels des Verbindungsmittels 4 mit dem Halbleiterkörper 1 verbunden.

In abschließenden Verfahrensschritten, Figur 4E, wird der Zwischenträger 5 entfernt und der Waferverbund kann in einzelne Leuchtdiodenchips vereinzelt werden.

In Verbindung mit den Figuren 5A, 5B, 5C, 5D und 5E ist ein alternatives Herstellungsverfahren für hier beschriebene Leuchtdiodenchips erläutert.

Bei dieser Variante des Herstellungsverfahrens wird zunächst eine Leuchtdiodenchipstruktur umfassend ein Aufwachssubstrat 9, einen n-leitenden Bereich 12, einen aktiven Bereich 13 und einen p-leitenden Bereich 11 bereitgestellt. Diese Struktur kann beispielsweise im Waferverbund vorliegen. An diese Struktur wird ein Zwischenträger 5 mittels eines weiteren Verbindungsmittels 6, vorliegend beispielsweise eines Lots, aufgebracht, Figur 5A.

In einem nächsten Verfahrensschritt, Figur 5B, wird das Aufwachssubstrat beispielsweise mittels Laser-Lift-off abgelöst und es erfolgt die Herstellung der Aufrauung 15 an der dem Zwischenträger 5 abgewandten Seite des n-leitenden Bereichs 12 des Halbleiterkörpers 1.

In einem nächsten Verfahrensschritt, Figur 5C, erfolgt das Verbinden der Struktur mit dem Träger 3 mittels des Verbindungsmittels 4.

Nachfolgend, Figur 5D, wird der Zwischenträger 5 entfernt.

In abschließenden Verfahrensschritten, Figur 5E erfolgt die elektrische Kontaktierung durch Aufbringen der Kontaktstellen 2A, 2B und gegebenenfalls der Kontaktschicht 14 sowie ein Zertrennen in einzelne Leuchtdiodenchips.

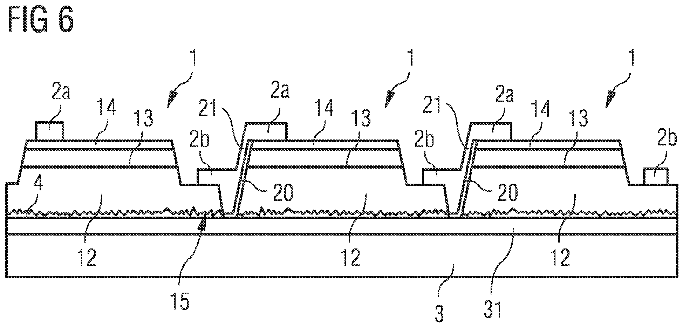

Anhand der Figur 6 ist ein weiteres Ausführungsbeispiel eines hier beschriebenen Leuchtdiodenchips mittels einer schematischen Schnittdarstellung näher erläutert. Im Unterschied beispielsweise zum Ausführungsbeispiel der Figur 2 umfasst der Leuchtdiodenchip eine Vielzahl von Halbleiterkörpern 1. Die Halbleiterkörper 2 sind benachbart zueinander auf dem Träger 3 angeordnet. Die Ausführung des Trägers 3 kann dabei wie in einer der Figuren 1A, 1B, 1C, 2 oder 3 gezeigt gewählt werden.

Benachbarte Halbleiterkörper 1 sind vorliegend in Reihe zueinander geschaltet. Beispielsweise sind alle Halbleiterkörper 1 in Reihe verschaltet. Dazu sind ungleichnamige Kontaktstellen 2a, 2b benachbarter Halbleiterkörper mittels der Verbindungsschicht 21 elektrisch leitend miteinander verbunden. Die Verbindungsschicht 21 besteht beispielsweise aus einem Metall oder einem transparenten leitfähigen Oxid. Beispielsweise ist die Verbindungsschicht 21 aus dem gleichen Material wie die Kontaktstellen 2a, 2b gebildet.

Damit die Verbindungsschicht 21 die jeweiligen Halbleiterkörper an ihrem jeweiligen aktiven Bereich 13 nicht kurzschließen kann, ist zwischen dem Halbleiterkörper und der Verbindungsschicht jeweils eine Passivierungsschicht 20 angeordnet. Die Passivierungsschicht 20 kann beispielsweise durch eine Schicht aus Siliziumdioxid gebildet sein.

Insgesamt kann auf diese Weise ein Leuchtdiodenchip mit vielen Pixeln realisiert sein. Vorliegend bildet der Leuchtdiodenchip einen Hochvoltleuchtdiodenchip, der mit Spannungen von beispielsweise größer 8 V betrieben werden kann.

Diese Patentanmeldung beansprucht die Priorität der deutschen Patentanmeldung 102010036180.

Die Erfindung ist nicht durch die Beschreibung anhand der Ausführungsbeispiele auf diese beschränkt.

## Patentansprüche

1. Leuchtdiodenchip mit
- einem Halbleiterkörper (1), der einen strahlungserzeugenden aktiven Bereich (13) umfasst,
- zumindest zwei Kontaktstellen (2a, 2b) zum elektrischen Kontaktieren des aktiven Bereichs,
- einem Träger (3), und
- einem Verbindungsmittel (4), das zwischen dem Träger (3) und dem Halbleiterkörper (1) angeordnet ist, wobei
- der Halbleiterkörper (1) an seiner dem Träger (3) zugewandten Außenflächen eine Aufrauung (15) aufweist,
- die Aufrauung (15) Erhebungen (15b) und Senken (15a) aufweist,
- der Halbleiterkörper (1) mittels des Verbindungsmittels (4) mechanisch mit dem Träger (3) verbunden ist,
- das Verbindungsmittel (4) stellenweise in direktem Kontakt mit dem Halbleiterkörper (1) und dem Träger (3) steht,
- die zumindest zwei Kontaktstellen (2a, 2b) an der dem Träger (3) abgewandten Oberseite des Halbleiterkörpers (1) angeordnet sind,
- das Verbindungsmittel (4) ein elektrisch isolierender Klebstoff ist, und
- das Verbindungsmittel (4) strahlungsdurchlässig ist, **dadurch gekennzeichnet, dass**
- der Halbleiterkörper (1) stellenweise in direktem Kontakt mit dem Träger (3) steht, und
- das Verbindungsmittel (4) zumindest stellenweise in den Senken (15a) angeordnet ist und Spitzen der Erhebungen (15b) stellenweise frei vom Verbindungsmittel (4) sind.

2. Leuchtdiodenchip nach dem vorherigen Anspruch,
bei dem
- der Träger (3) strahlungsdurchlässig ist,
- die die dem Halbleiterkörper (1) zugewandte Oberseite des Trägers (3) eine Saphir A-Ebene ist.

3. Leuchtdiodenchip nach Anspruch 1 oder 2,
bei dem
die Spitzen der Erhebungen (15b) in direktem Kontakt mit dem Träger (3) stehen.

4. Leuchtdiodenchip nach Anspruch 1,
bei dem der Träger (3) strahlungsdurchlässig ist.

5. Leuchtdiodenchip nach Anspruch 1,
bei dem die dem Halbleiterkörper (1) zugewandte Oberseite des Trägers (3) eine Saphir A-Ebene ist.

6. Leuchtdiodenchip nach Anspruch 1,
bei dem der Träger (3) strahlungsreflektierend ist.

7. Leuchtdiodenchip nach einem der vorherigen Ansprüche,
bei dem der Träger (3) an seiner dem Halbleiterkörper (1) zugewandten Oberseite eine reflektierende Schicht (31) umfasst, die zur Reflexion von im aktiven Bereich (13) erzeugter elektromagnetischer Strahlung reflektierend ausgebildet ist.

8. Leuchtdiodenchip nach Anspruch 1,
bei dem der Träger (3) mit einem metallischen Material gebildet ist.

9. Leuchtdiodenchip nach Anspruch 1,
bei dem der Träger (3) strahlungsstreuend ausgebildet ist.

10. Leuchtdiodenchip nach Anspruch 1,
bei dem der Träger (3) mit einem keramischen Material gebildet ist.

11. Leuchtdiodenchip nach einem der vorherigen Ansprüche,
bei dem die dem Träger (3) zugewandte Seite des Halbleiterkörpers (1) ein n-leitendes Halbleitermaterial (12) umfasst und sich von der dem Träger (3) abgewandten Seite her zumindest eine Durchkontaktierung (8) von einer der zumindest zwei Kontaktstellen (2b) durch der aktiven Bereich (13) hindurch zum n-leitenden Halbleitermaterial (12) erstreckt.

## Claims

1. Light-emitting diode chip with
- a semiconductor body (1) which comprises a radiation-generating active region (13),
- at least two contact points (2a, 2b) for electrically contacting the active region,
- a carrier (3), and
- a bonding agent (4) which is arranged the between the carrier (3) and the semiconductor body (1),
- the semiconductor body (1) having a roughening (15) on the outer faces thereof which face the carrier (3),
- the roughening (15) having projections (15b) and depressions (15a),
- the semiconductor body (1) being mechanically connected to the carrier (3) by means of the bonding agent (4),
- the bonding agent (4) being in places in direct contact with the semiconductor body (1) and the carrier (3),
- the at least two contact points (2a, 2b) being arranged on the topside of the semiconductor body (1) remote from the carrier (3),
- the bonding agent (4) being an electrically insulating adhesive, and
- the bonding agent (4) being radiation-transmissive, **characterized in that**
- the semiconductor body (1) is in places in direct contact with the carrier (3), and
- the bonding agent (4) is arranged at least in places in the depressions (15a) and tips of the projections (15b) are in places free of the bonding agent (4).

2. Light-emitting diode chip according to the preceding claim,
in which
- the carrier (3) is radiation-transmissive,
- the top of the carrier (3) facing the semiconductor body (1) is a sapphire A-plane.

3. Light-emitting diode chip according claim 1 or 2,
in which
the tips of the projections (15b) are in direct contact with the carrier (3).

4. Light-emitting diode chip according to claim 1, in which the carrier (3) is radiation-transmissive.

5. Light-emitting diode chip according to claim 1, in which the top of the carrier (3) facing the semiconductor body (1) is a sapphire A-plane.

6. Light-emitting diode chip according to claim 1, in which the carrier (3) is radiation-reflective.

7. Light-emitting diode chip according to one of the preceding claims, in which the carrier (3) comprises, on the topside thereof facing the semiconductor body (1), a reflective layer (31) which is formed in a reflective manner for reflecting electromagnetic radiation generated in the active region (13).

8. Light-emitting diode chip according to claim 1, in which the carrier (3) is formed with a metallic material.

9. Light-emitting diode chip according to claim 1, in which the carrier (3) is built in a radiation-scattering manner.

10. Light-emitting diode chip according to claim 1, in which the carrier (3) is formed with a ceramic material.

11. Light-emitting diode chip according to one of the preceding claims, in which the side of the semiconductor body (1) facing the carrier (3) comprises an n-conductive semiconductor material (12), and at least one through-via (8) extends from the side remote from the carrier (3) from one of the at least two contact points (2b) through the active region (13) to the n-conductive semiconductor material (12).

## Revendications

1. Puce de diode électroluminescente comprenant
- un corps semi-conducteur (1) qui comprend une zone active (13) générant un rayonnement,
- au moins deux points de contact (2a, 2b) pour la mise en contact électrique de la zone active,
- un support (3) et
- un moyen de liaison (4) qui est disposé entre le support (3) et le corps semi-conducteur(1),
- le corps semi-conducteur (1) présentant une rugosité (15) sur sa surface extérieure tournée vers le support (3),
- la rugosité (15) présentant des élévations (15b) et des creux (15a),
- le corps semi-conducteur (1) étant raccordé mécaniquement au support (3) au moyen du moyen de liaison (4),
- le moyen de liaison (4) étant par endroits en contact direct avec le corps semi-conducteur (1) et le support (3),
- les au moins deux points de contact (2a, 2b) étant disposés sur le côté supérieur, détourné du support (3), du corps semi-conducteur (1),
- le moyen de liaison (4) étant une colle électriquement isolante, et
- le moyen de liaison (4) étant perméable au rayonnement, **caractérisée en ce que**
- le corps semi-conducteur (1) est par endroits en contact direct avec le support (3), et
- **en ce que** le moyen de liaison (4) est disposé dans les creux (15a) au moins par endroits et **en ce que** des pointes des élévations (15b) sont par endroits exemptes du moyen de liaison (4).

2. Puce de diode électroluminescente selon la revendication précédente,
dans laquelle
- le support (3) est perméable au rayonnement,
- le côté supérieur du support (3), tourné vers le corps semi-conducteur (1), est un plan A de saphir.

3. Puce de diode électroluminescente selon la revendication 1 ou 2,
dans laquelle
les pointes des élévations (15b) sont en contact direct avec le support (3).

4. Puce de diode électroluminescente selon la revendication 1, dans laquelle le support (3) est perméable au rayonnement.

5. Puce pour diode électroluminescente selon la revendication 1, dans laquelle le côté supérieur du support (3), tourné vers le corps semi-conducteur (1), est un plan A de saphir.

6. Puce de diode électroluminescente selon la revendication 1, dans laquelle le support (3) est à réfléchissement de rayonnement.

7. Puce de diode électroluminescente selon l'une quelconque des revendications précédentes, dans laquelle le support (3) comprend sur son côté supérieur tourné vers le corps semi-conducteur (1) une couche réfléchissante (31) qui est réalisée de manière réfléchissante pour la réflexion de rayonnement électromagnétique généré dans la zone active (13).

8. Puce de diode électroluminescente selon la revendication 1,
dans laquelle le support (3) est formé par une matière métallique.

9. Puce de diode électroluminescente selon la revendication 1,
dans laquelle le support (3) est réalisé de manière à diffuser le rayonnement.

10. Puce de diode électroluminescente selon la revendication 1,
dans laquelle le support (3) est formé par une matière céramique.

11. Puce de diode électroluminescente selon l'une quelconque des revendications précédentes, dans laquelle le côté du corps semi-conducteur (1), tourné vers le support (3), comprend une matière semi-conductrice (12) à conduction n et en ce qu'à partir du côté détourné du support (3) s'étend au moins une connexion entière (8) de l'un des au moins deux points de contact (2b) à travers la zone active (13) en direction de la matière semi-conductrice (12) à conduction n.
